# EUROPEAN PATENT APPLICATION

(11) **EP 2 487 725 A2**
(43) Date of publication of application: **15.08.2012**
(21) Application number: 10839827.2
(22) Date of filing: 24.12.2010
(51) Int. Cl.: H01L 31/042, H01L 31/048

(54) **SOLAR POWER GENERATING APPARATUS**

(30) Priority: 24.12.2009 KR 20090131227
(71) Applicant: LG Innotek Co., Ltd., Seoul 100-714 (KR)
(72) Inventor: JEE, Suk Jae, Seoul 100-714 (KR)
(74) Representative: Novagraaf Technologies
(86) International application number: PCT/KR2010/009337
(87) International publication number: WO 2011/078630

(57) **Abstract**

Provided is a photovoltaic apparatus. The photovoltaic apparatus includes first and second transparent substrates; a number of solar cells interposed between the first and second transparent substrates, and orthogonal to or inclined to first transparent substrates; and a number of connecting members connecting each of the solar cells to each other. The photovoltaic apparatus allows the solar cells to be slantly arranged to the transparent substrate, thereby to improve power generation efficiency and to increase an area of a transmission region.

## Description

### [Technical Field]

The present invention relates to a photovoltaic apparatus.

### [Background Art]

A photovoltaic module converting light energy into electrical energy by using photoelectric conversion effect has been widely used as means of obtaining pollution-free energy that contributes to the preservation of the global environment.

As photoelectric conversion efficiency of the solar cells is improved, many photovoltaic apparatus providing the photovoltaic module has been arranged as cladding for household and commercial buildings.

### [Disclosure]

### [Technical Problem]

An advantage of some aspects of the invention is that it provides a photovoltaic apparatus having a wide transmission region and improved power generation efficiency, and capable of being used in an outer wall of the building, and windows and doors, etc.

### [Technical Solution]

The photovoltaic apparatus of an embodiment includes first and second transparent substrates facing each other; a number of solar cells interposed between the first and second transparent substrates, and orthogonal to or inclined to first transparent substrate; and a number of connecting members connecting each of the solar cells to each other.

The photovoltaic apparatus of an embodiment includes a first transparent substrate; a number of solar cells arranged on the first transparent substrate, and intersecting with the first transparent substrate; and a supporting member arranged on the first transparent substrate, and supporting the solar cells.

The photovoltaic apparatus of an embodiment includes a first transparent substrate; a number of power generation units arranged on the first transparent substrate, intersecting with the first transparent substrate and converting solar light to be entered into electrical energy; and a second transparent substrate facing the first transparent substrate and surrounding the power generation units.

### [Advantageous Effects]

The photovoltaic apparatus of an embodiment includes the solar cells orthogonal to or inclined to the transparent substrate. Therefore, the photovoltaic apparatus of the embodiment has a wide transmission region.

Further, when the photovoltaic apparatus of the embodiment is used as the windows and doors, the solar light incident from the outside may be efficiently entered the solar cells 300. That is, the windows and doors are used in a standing state, thereby to improve an incident angle of solar light for the solar cell.

For example, the photovoltaic apparatus of the embodiment may improve the incident angle of the solar light for the solar cell rather than the case in which the solar cells are horizontal to the transparent substrate.

Therefore, the photovoltaic apparatus of the embodiment has a wide transmission region and improved power generation efficiency.

Further, the photovoltaic apparatus of the embodiment may be used in an outer wall of the building, and windows and doors, etc.

### [Description of Drawings]

FIG. 1 is a disassembled prospective view showing a photovoltaic apparatus according to an embodiment.
FIG. 2 is a sectional view of the photovoltaic apparatus according to an embodiment.
FIG. 3 is a sectional view of the photovoltaic apparatus according to another embodiment.
FIG. 4 is a plan view showing a solar cell.
FIG. 5 is a sectional view taken by line A-A' of FIG. 4.
FIG. 6 shows the process connecting the solar cells to each other.
FIG. 7 shows the process in which solar light is incident on the solar cells.
FIG. 8 is a sectional view of the solar cells according to another embodiment.
FIG. 9 shows the process connecting the solar cells to each other according to another embodiment.

### [Best Mode]

Hereinafter, an exemplary embodiment of the disclosure will be described in detail with reference to drawings. However, the disclosure cannot be limited to the embodiment in which the idea of the disclosure is presented, another embodiment included within range of idea of another backward disclosure or the closure may be easily proposed by addition, change, deletion and the like of another constituent.

In the description of the embodiment, in a case where each substrate, layer, a film or a electrode and the like is described to be formed "on" or "under" thereof, "on" or "under" also means one to be formed "directly" or "indirectly(through other component)" to component. Also, the criteria regarding "on" or "under" of each component will be described based on the drawings. In the drawing, the size of each component may be exaggerated to describe, and does not mean the size that is in fact applied.

### [Mode for Invention]

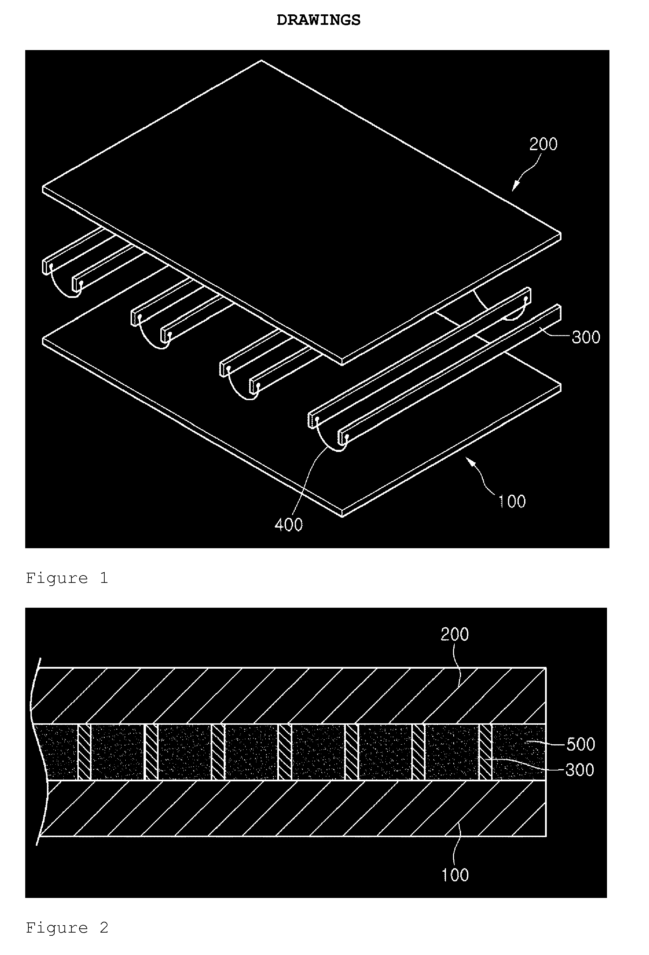

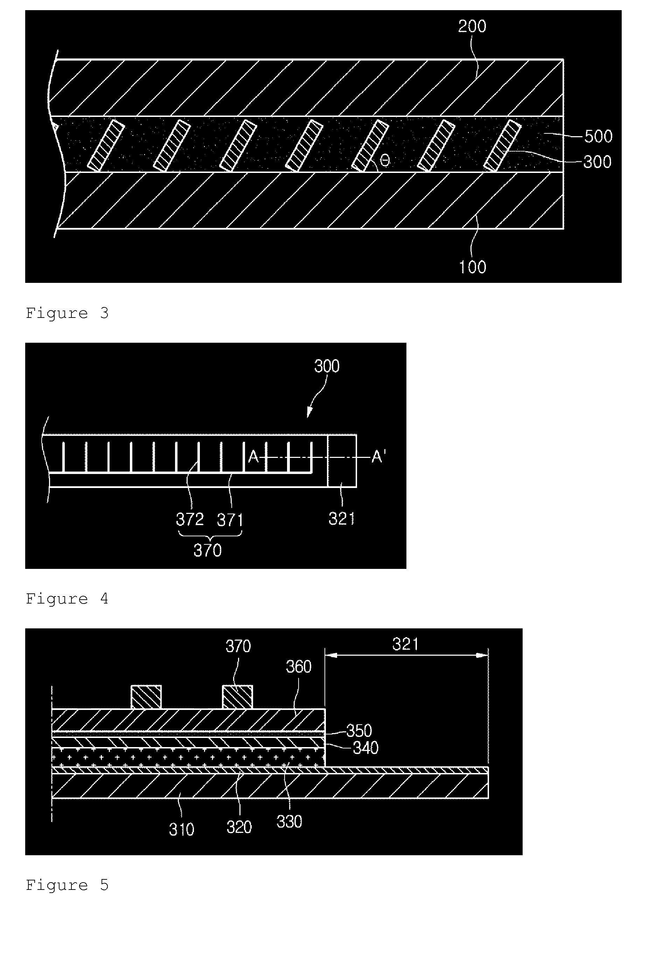

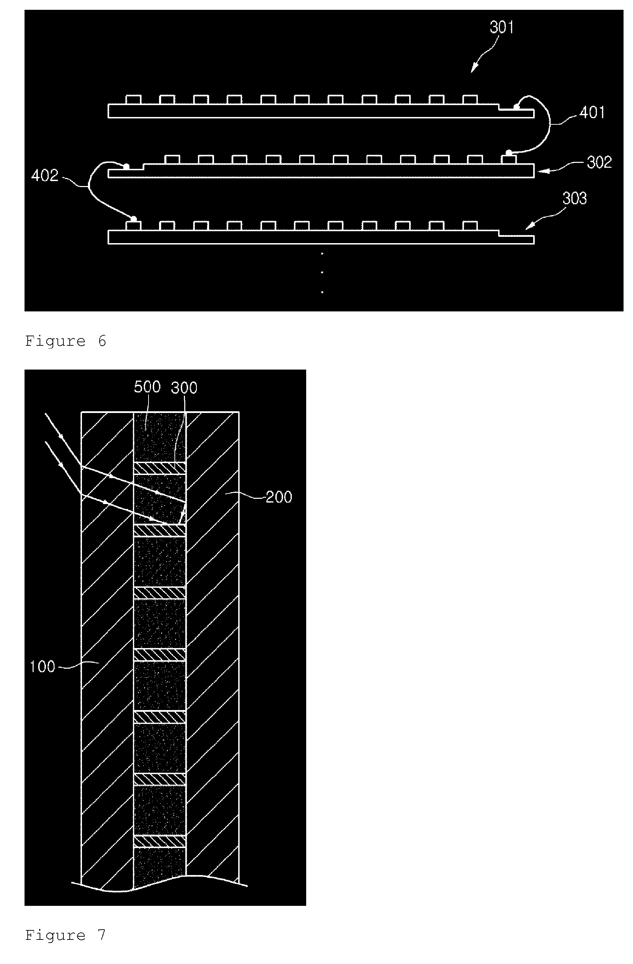

FIG. 1 is a disassembled prospective view showing a photovoltaic apparatus according to the embodiment. FIG. 2 is a sectional view showing photovoltaic apparatus according to the embodiment. FIG. 3 is a sectional view of the photovoltaic apparatus according to another embodiment. FIG. 4 is a plan view showing a solar cell. FIG. 5 is a sectional view taken by line A-A' of FIG. 4. FIG. 6 shows the process connecting solar cells to each other. FIG. 7 shows the process in which solar light is incident on the solar cells.

Referring to FIG. 1 to 7, the photovoltaic apparatus of the embodiment includes a first transparent substrate 100, a second transparent substrate 200, a number of solar cells 300, a number of connecting members 400 and a sealing member 500.

The first transparent substrate 100 is transparent, and has a plate shape. The first transparent substrate 100 is an insulator. The first transparent substrate 100 may be for example, glass substrate or plastic substrate. In more detail, materials used as the first transparent substrate 100 are, for example, glass, tempered glass or transparent polymer etc. In more detail, the materials used as the first transparent substrate 100 are, for example, poly methyl methacrylate(PMMA), acrylonitrile styrene(AS), polystyrene(PS), polycarbonate(PC), polyethersulfone(PES), polyamide(PA), polyesterimide(PEI) and polymethylpentene(PMP) etc.

The second transparent substrate 200 is arranged on the first transparent substrate 100. The second transparent substrate 200 is spaced apart from the first transparent substrate 100, and faces the first transparent substrate 100.

The second transparent substrate 200 is transparent, and has a plate shape. The second transparent substrate 200 is an insulator. The second transparent substrate 200 may be for example, a glass substrate or a plastic substrate. In more detail, materials used as the second transparent substrate 200 are, for example, glass, tempered glass or transparent polymer etc. In more detail, the materials used as the second transparent substrate 200 are, for example, poly methyl methacrylate(PMMA), acrylonitrile styrene(AS), polystyrene(PS), polycarbonate(PC), polyethersulfone(PES), polyamide(PA), polyesterimide(PEI) and polymethylpentene(PMP) etc.

The solar cells 300 are arranged on the first transparent substrate 100. In more detail, the solar cells 300 are interposed between the first transparent substrate 100 and the second transparent substrate 200. The solar cells 300 face each other, and are spaced apart from each other. The solar cells 300 may be arranged in parallel to each other. The solar cells 300 may be spaced apart from each other at the same interval in substance. That is, the solar cells 300 may be spaced apart at intervals corresponding to each other.

As shown in FIG. 2 and 3, the solar cells 300 intersect with the first transparent substrate 100 and the second transparent substrate 200. That is, the solar cells 300 are orthogonal to the first transparent substrate 100 and the second transparent substrate 200 or may be inclined to the first transparent substrate 100 and the second transparent substrate 200.

For example, as shown in FIG.2, a angle between the first and second transparent substrate 100, 200 and the solar cells 300 may be about 90°. Further, as shown in FIG.2, the solar cells 300 may be inclined to the angle of 0° to 90° for the first and second transparent substrate 100, 200. In more detail, the angle (θ) between the first and second transparent substrate 100, 200, and the solar cells 300 may be about 45° to 85°.

Intervals between the solar cells 300 and slopes (θ) of the solar cells 300 are suitably controlled to control the light incident on the solar cells 300. The Intervals between the solar cells 300 and the slopes (θ) of the solar cells 300 are suitably controlled, thereby maximizing photoelectric conversion efficiency for the photovoltaic apparatus of the embodiment.

The solar cells 300 receive solar light to convert into the electrical energy. That is, the solar cells 300 are power generation units generating the solar light into the electrical energy. The solar cells 300 may be, for example, CIGS-base solar cell, silicon-base solar cell, dye-sensitized-base solar cell, group II-VI compound semiconductor solar cell or group III-V compound semiconductor solar cell.

For example, the solar cells 300 may include a first electrode, a photoelectric conversion layer arranged on the first electrode, and a second electrode arranged on the photoelectric conversion layer. Here, the photoelectric conversion layer is a light absorption layer for absorbing the solar light.

As shown in FIG. 4 and 5, the solar cells 300 may include a supporting substrate 310, a back electrode layer 320, a light absorption layer 330, a buffer layer 340, a high-resistive buffer layer 350, a window layer 360, and at least one grid electrodes 370.

The supporting substrate 310 is an insulator and supports the back electrode layer 320, the light absorption layer 330, the buffer layer 340, the high-resistive buffer layer 350, the window layer 360, and the grid electrodes 370. The supporting substrate 310 may be flexible. The supporting substrate 310 may be a stainless steel substrate, a glass substrate, or a plastic substrate.

The back electrode layer 320 is arranged on the supporting substrate 310. The backside electrode layer 320 becomes a conductive layer. The material used as the back electrode layer 320 is, for example, molybdenum etc. The back electrode layer 320 is formed in end thereof, and includes a terminal 321 to be exposed outside.

The light absorption layer 330 is arranged on the back electrode layer 320. The light absorption layer 330 contains group I-III-VI-base compound. For example, The light absorption layer 330 may has copper-indium-gallium-selenide-base(Cu(In,Ga)Se2;CIGS-base) or copper-indium-selenide-base crystal structure.

The energy band gap of the light absorption layer 330 may be about 1eV to 1.8eV.

The buffer layer 330 is arranged on the light absorption layer 330. The buffer layer 340 is directly formed on the light absorption layer 330. That is, the buffer layer 340 directly contacts the light absorption layer 330. The material used as the back electrode layer 340 is, for example, cadmium sulfide etc.

The energy band gap of the buffer layer 340 may be about 2.0 eV to 2.5 eV. A thickness of the buffer layer 340 may be about 50 nm to 150 nm.

The high-resistive buffer layer 350 is arranged on the buffer layer 340. The high-resistive buffer layer 350 contains zinc oxide (i-ZnO) not doped with impurity. The energy bandgap of the high-resistive buffer layer 350 may be about 3.1eV to 3.3eV.

The window layer 360 is arranged on the high-resistive buffer layer 350. The window layer 360 is transparent and a conductive layer.

The material used as the window layer 360 is, for example, Al doped ZnO (AZO) or induim tin oxide(ITO) etc.

The light absorption layer 330, the buffer layer 340, the high-resistive buffer layer 350 and the window layer 360 allow the terminal 321 to be exposed. The light absorption layer 330, the buffer layer 340, the high-resistive buffer layer 350 and the window layer 360 are not arranged in the terminal 321.

The grid electrodes 370 are arranged on the window layer 360. The grid electrodes 370 are connected to the window layer 360. The material used as the back electrode layer 370 is, for example, silver(Ag) etc. The grid electrodes 370 assist electron collecting capacity of the window layer 360.

For example, the solar cells 300 have a shape long-extended in one direction, and the connecting members 400 are connected to the end of the solar cells 300. As a result, since the solar cells 300 have a long-extended shape and high resistance. That is, since the window layer 360 has high resistivity and has a long-extended shape, the window layer 360 has high resistance.

Therefore, it is not easy to move electrons produced from the light absorption layer 330 into the connecting members 400 along the window layer 360 only. At this moment, since the grid electrodes 370 are connected to the window layer 360 and have relatively low resistance, it is easy to move the electron That is, the grid electrodes 370 lower the entire resistance of the solar cells 300, and may improve the photoelectric conversion efficiency of the photovoltaic apparatus of the embodiment.

The grid electrodes 370 may be main grid electron 371 and a number of subgrid electrodes 372. The main grid electrode 371 is long-extended along the direction in which the solar cells 300 are extended. The sub grid electrodes 372 are extended in the direction intersecting with direction extended with the solar cells 300 from the main grid electrode 371.

In the solar cells 300, a surface on which the light is incident is arranged upward. For example, in the solar cells 300, the window layer 360 is arranged upward.

The solar cells 300 are connected to each other by the connecting members 400. The solar cells 300 may be connected in series, in parallel, or in series and parallel by the connecting members 400. The connecting members 400 may be conductive tapes or conductive wires.

The connecting members 400 may be arranged on a side of the first transparent substrate 100. That is, The solar cells 300 are protruded from the side of the transparent substrate, and the connecting members 400 may be connected to the protruded portion of the solar cells 300.

In contrast, the connecting members 400 may be interposed between the first transparent substrate 100 and the second transparent substrate 200.

As shown in FIG.6, the connecting members 400 are connected to the terminal 321 and the grid electrodes 370. For example, a first connecting member 401 is connected to the terminal of the first solar cell 301, and is connected to the grid electrodes of the second solar cell 302. Further, a second connecting member 402 is connected to the terminal of the second solar cell 302, and the grid electrodes of the third solar cell 303. Thus, the first solar cell 301, the second solar cell 302 and the third solar cell 303 may be connected in series by the first connecting member 401 and the second connecting member 402.

The sealing member 500 is interposed between the first transparent substrate 100 and the second transparent substrate 200. The sealing member 500 is filler to be filled between the first transparent substrate 100 and the second transparent substrate 200. Further, the sealing member 500 is adhered to the first transparent substrate 100 and the second transparent substrate 200. Therefore, the sealing member 500 is an adhesive adhering the first transparent substrate 100 and the second transparent substrate 200.

Further, the sealing member 500 is a supporting member supporting the solar cells 300. That is, the solar cells 300 may be fastened to be intersected with the first transparent substrate 100 at a predetermined angle by the sealing member 500.

The sealing member 500 surrounds each of the solar cells 300. The sealing member 500 seals each of the solar cells 300. That is, the sealing member 500 is adhered to the solar cells 300. The sealing member 500 prevents the solar cells 300 from penetrating foreign matter such as moisture.

Further, the sealing member 500 may surround the connecting members 400. That is, the sealing member 500 may be adhered to the connecting members 400. The sealing member 500 seals the solar cells 300 and the connecting members 400, thereby to prevent corrosion caused by the foreign matter such as the moisture.

The sealing member 500 is transparent and is an insulator. The material used as the sealing member 550 is, for example, transparent resin etc. such as ethylene vinyl acetate(EVA). Further, the material used as the sealing member 550 is, for example, a thermoplastic resin, a thermosetting resin or a light-curable resin etc.

Refractive indexes of the sealing member 500, the first transparent substrate 100 and the second transparent substrate 100 are suitably controlled to implement optimal photoelectric conversion efficiency. That is, the sealing member 500 may be an optical member for improving an optical characteristic of the photovoltaic apparatus of the embodiment.

For example, the sealing member 500 may has the refractive index higher than that of the first transparent substrate 100 and the second transparent substrate 200. In contrast, the sealing member 500 may has the refractive index corresponding to the first transparent substrate 100 and the second transparent substrate 200.

Further, the photovoltaic apparatus of the embodiment further includes a frame surrounding sides of the first transparent substrate 100 and the second transparent substrate 200, and a junction box etc. transferring the electrical energy produced from the solar cells 300 to the photovoltaic apparatus or a power storage unit adjacent to it.

As shown in FIG. 7, the photovoltaic apparatus of the embodiment may be used as windows and doors etc. in a standing state.

At this moment, since the solar cells 300 is orthogonal to, or is inclined to the first transparent substrate 100 and the second transparent substrate 200, the photovoltaic apparatus of the embodiment has a wide penetration region. That is, the photovoltaic apparatus of the embodiment has a wider transmission region rather than the case in which the solar cells 300 are horizontal to the transparent substrate.

In more detail, when the solar cells 300 are orthogonal to the first and second transparent substrate 100, 200, the remaining portion except the portion corresponding to the side of the solar cells 300 may become a transmission region.

Further, when the photovoltaic apparatus of the embodiment is used as the windows and doors, the solar light incident from the outside may be efficiently entered the solar cells 300. That is, when the photovoltaic apparatus of the embodiment is used as the windows and doors, the first and second transparent substrate 100, 200 are generally build in the direction orthogonal to the surface of the earth. At this moment, the solar cells 300 are intersected with the first and second transparent substrate 100, 200, and therefore, may be arranged to have an optimal incident angle of the solar light.

As shown in FIG. 7, the photovoltaic apparatus of the embodiment may suitably control the incident angle of the solar light for the solar cells 300 rather than the case in which the solar cells 300 are horizontal to the first and second transparent substrate 100, 200.

Particularly, when the refractive index of the sealing member 500 is larger than that of the first transparent substrate 100, a total reflection is reduced at an interface between the sealing member 500 and the first transparent substrate 100. Further, when the refractive index of the sealing member 500 is larger than that of the second transparent substrate 200, the light reflected at an interface between the sealing member 500 and the second transparent substrate 200 may be again entered the solar cells 300.

Therefore, the photovoltaic apparatus of the embodiment has a wide transmission region and improved power generation efficiency.

Further, the photovoltaic apparatus of the embodiment may be used as an outer wall of the building, and windows and doors, etc.

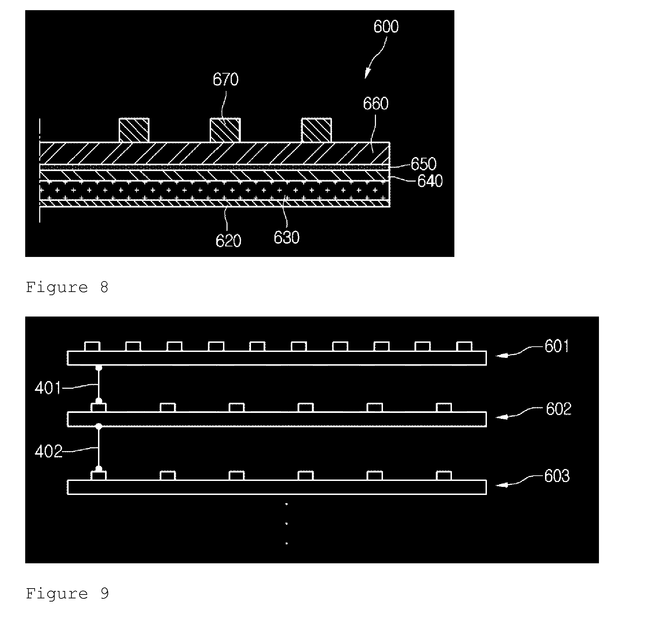

FIG. 8 is a sectional view showing the solar cells according to another embodiment. FIG. 9 shows the process connecting the solar cells to each other according to another embodiment. In the present embodiment, the solar cells and the connecting members will be further described with reference to the above-described embodiment. The description of the preceding embodiment may be essentially combined with the description of the present embodiment except the changed portion.

In FIG. 8, solar cells 600 include a conductive substrate 620, a light absorption layer 630, a high-resistive buffer layer 650, a window layer 660 and grid electrodes 670.

The conductive substrate 620 is a conductor and flexible. The material used as the conductive substrate 620 is, for example, copper, aluminum or their alloy etc. The conductive substrate 620 supports the light absorption layer 630, the buffer layer 640, the high-resistive buffer layer 650, the window layer 660, and the grid electrodes 670.

The conductive substrate 620 performs a function of the back electrode. That is, the conductive substrate 620 is connected to the light absorption layer 630, and receives charges generated from the light absorption layer 630.

The light absorption layer 630, the buffer layer 640, the high-resistive buffer layer 650, the window layer 660, and the grid electrodes 670 are sequentially laminated on the conductive substrate 620.

Referring to FIG. 9, the connecting members are connected to the grid electrodes 670 and the conductive substrate 620, respectively. For example, a first connecting member 401 is connected to the conductive substrate of the first solar cell 601, and is connected to the grid electrodes of the second solar cell 402. Further, a second connecting member 402 is connected to the conductive substrate of the second solar cell 602, and the grid electrodes of the third solar cell 603.

The conductive substrate 620 performs a function of the back electrode and the supporting substrate. Therefore, since the solar cells 600 do not include the supporting substrate separately, the solar cells 600 have a very thin thickness.

As a result, the photovoltaic apparatus of the embodiment has a wider transmission region.

Further, it is not necessary to form the terminal in the solar cells 600. Therefore, the solar cells 600 may be easily connected to each other.

Thus, the photovoltaic apparatus of the embodiment has a simple structure.

It is appreciated that the present invention can be carried out in other specific forms without changing a technical idea or essential characteristics by one having ordinary skilled in the art to which the present invention pertains to. Therefore, embodiments described above are for illustration purpose in all respect but not limited to them. The scope of the present invention is represented by claims described below rather than the detailed description, and any change and variations derived from the meaning, the scope and the concept of equality of claims should be interpreted to be included to the scope of the present invention.

In addition, although the preferred embodiments of the present invention are shown and described above, the present invention is not limited to above-described specific embodiment and is variously modified by one skilled in the art without the gist of the present invention claimed in the claim, such that the modified embodiment is not to be understood separately from technical ideas or views of the present invention.

### [Industrial Applicability]

The photovoltaic apparatus of the embodiment is used in the photovoltaic industry.

[Sequence List Text]

## Claims

1. A photovoltaic apparatus, comprising first and second transparent substrates; a number of solar cells interposed between the first and second transparent substrates, and orthogonal to or inclined to first transparent substrates; and a number of connecting members connecting each of the solar cells to each other.

2. The photovoltaic apparatus according to claim 1, further comprising a sealing member interposed between the first and second transparent substrates and surrounding the solar cells.

3. The photovoltaic apparatus according to claim 2, wherein the sealing member has a refractive index higher than that of the first and second transparent substrates.

4. The photovoltaic apparatus according to claim 2, wherein the sealing member is interposed between the solar cells, and is adhered to the solar cells.

5. The photovoltaic apparatus according to claim 2, wherein the sealing
member contains a thermosetting resin or a light-curable resin.

6. The photovoltaic apparatus according to claim 1, wherein the solar cells include a supporting substrate; a back electrode layer arranged on the supporting substrate; a light absorption layer arranged on the back electrode layer; a window layer arranged on the light absorption layer; and a number of grid electrodes arranged on the window layer.

7. The photovoltaic apparatus according to claim 6, wherein the light absorption layer allows the portion of the back electrode layer to be exposed.

8. The photovoltaic apparatus according to claim 6, wherein the solar cells are connected to each other in series.

9. The photovoltaic apparatus according to claim 1, wherein the solar cells include a conductive substrate; a light absorption layer arranged on the conductive substrate; a window layer arranged on the light absorption layer; and grid electrodes arranged on the window layer, wherein the connecting members are connected to the conductive substrate or the grid electrodes.

10. The photovoltaic apparatus according to claim 1, wherein the solar cells are flexible.

11. The photovoltaic apparatus according to claim 1, wherein the solar cells has a shape to be extend in one direction, and include the grid electrode to be extended in the one direction.

12. A photovoltaic apparatus, comprising: a first transparent substrate; a number of solar cells arranged on the first transparent substrate, and intersecting with the first transparent substrate; and a supporting member arranged on the first transparent substrate, and supporting the solar cells.

13. The photovoltaic apparatus according to claim 12, wherein the supporting member is transparent, and is adhere to the solar cells and the first transparent substrate.

14. The photovoltaic apparatus according to claim 12, further comprising a second transparent substrate surrounding the solar cells and the supporting member, wherein the supporting member is adhered to the first and second transparent substrates.

15. The photovoltaic apparatus according to claim 12, further comprising connecting members connecting the solar cells to each other in parallel or in series.

16. The photovoltaic apparatus, comprising: a first transparent substrate; a number of power generation units arranged on the first transparent substrate, and converting solar light to be entered into electrical energy; and a second transparent substrate facing the first transparent substrate and surrounding the power generation units.

17. The photovoltaic apparatus according to claim 16, wherein the power generation units include a first electrode; a light absorption layer arranged on the first electrode; a second electrode arranged on the light absorption layer.

18. The photovoltaic apparatus according to claim 17, further comprising a connecting member connecting the power generation units to each other, wherein the connecting members are connected to the first or second electrodes.

19. The photovoltaic apparatus according to claim 16, wherein an angle between the power generation units and the first transparent substrate is about 45° to 85°.

20. The photovoltaic apparatus according to claim 16, wherein the angle between the power generation units and the first transparent substrate is about 90°.
